## Europäisches Patentamt
## European Patent Office
## Office européen des brevets

(19)

(11) Veröffentlichungsnummer: **0 047 045**
**B1**

(12) **EUROPÄISCHE PATENTSCHRIFT**

(45) Veröffentlichungstag der Patentschrift:
**28.03.84**

(51) Int. Cl.³: **H 05 K 13/00**, B 65 G 15/44

(21) Anmeldenummer: **81200969.4**

(22) Anmeldetag: **01.09.81**

(54) Vorrichtung zum Transportieren von auf einem Bandträger angeordneten elektrischen Bauelementen.

(30) Priorität: **02.09.80 DE 3032942**

(43) Veröffentlichungstag der Anmeldung:
**10.03.82 Patentblatt 82/10**

(45) Bekanntmachung des Hinweises auf die Patenterteilung:
**28.03.84 Patentblatt 84/13**

(84) Benannte Vertragsstaaten:
**DE FR GB**

(56) Entgegenhaltungen:
**DE - A - 2 530 832**
**DE - A - 2 542 278**
**GB - A - 2 046 210**

(73) Patentinhaber: **Philips Patentverwaltung GmbH,
Billstrasse 80, D-2000 Hamburg 28 (DE)**

(84) Benannte Vertragsstaaten: **DE**

(73) Patentinhaber: **N.V. Philips' Gloeilampenfabrieken,
Groenewoudseweg 1, NL-5621 BA Eindhoven (NL)**

(84) Benannte Vertragsstaaten: **FR GB**

(72) Erfinder: **Loscha, Franz, Friedrichsgaberweg 332,
D-2000 Norderstedt 3 (DE)**

(74) Vertreter: **Nehmzow-David, Fritzi-Maria et al, Philips
Patentverwaltung GmbH
Billstrasse 80 Postfach 10 51 49,
D-2000 Hamburg 28 (DE)**

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

## Vorrichtung zum Transportieren von auf einem Bandträger angeordneten elektrischen Bauelementen

Die Erfindung bezieht sich auf eine Vorrichtung zum Transportieren von auf einem Bandträger mit ihren Anschlussdrähten angeordneten elektrischen Bauelementen in einer Be- oder Verarbeitungsvorrichtung.

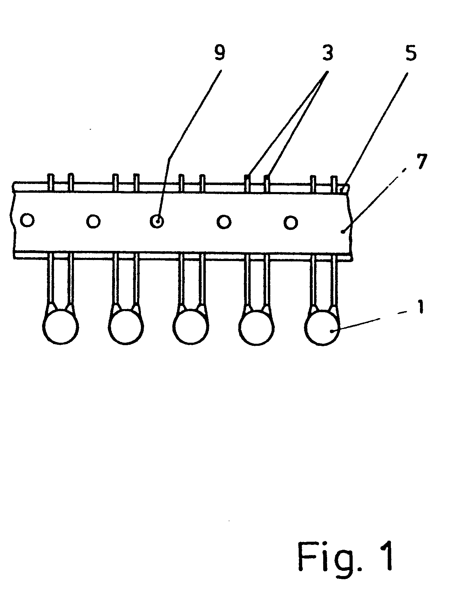

In Fig. 1 ist ein Beispiel für einen bekannten Bandträger für elektrische Bauelelemente gezeigt. Der bekannte Bandträger wird so hergestellt, dass die Anschlussdrähte 3 von elektrischen Bauelementen 1 auf ein Tragband 5 gelegt werden, dass ein Klebeband 7 darüber aufgebracht wird, um die Anschlussdrähte 3 auf dem Tragband 5 zu halten und dass danach Perforationslöcher 9 ausgebildet werden, um den Bandträger mittels in die Perforationslöcher 9 eingreifende Mitnehmer an einer z.B. endlosen Fördereinrichtung in z.B. einer Bearbeitungsvorrichtung zu transportieren und auch zu positionieren. Solche bekannte Bandträger sowie das Verfahren zur Herstellung dieser Bandträger haben den Nachteil, dass einmal die Anschlussdrähte 3 beim Transport der Bandträger und bei der Positionierung als Justierhilfe im Zuge der Herstellung der Perforationslöcher 9 mit herangezogen werden, so dass die Gefahr besteht, dass sich die Anschlussdrähte 3, die durch das Klebeband 7 auf dem Tragband 5 aufgeklebt sind, lösen. Wenn sich die Anschlussdrähte 3 lösen, wird die Position der Perforationslöcher 9 in bezug auf die Positionen der elektrischen Bauelemente 1 ungenau, so dass derart gegurtete Bauelemente nicht mehr korrekt weiterbearbeitet werden können, sei es in Messapparaturen, in Wirbelsinteranlagen zum Beschichten der Bauelemente mit einem Kunststoffüberzug oder auch in Bestückungsvorrichtungen zum Übertragen von gegurteten Bauelementen auf Leiterplatten.

Aber selbst wenn die Klebeverbindung zwischen Tragband und Klebeband so fest ist, dass die Anschlussdrähte mit Sicherheit zwischen Tragband und Klebeband gehalten werden, sich also nicht in bezug auf die Perforationslöcher verschieben, ergibt sich bei solcher Art gegurteter Bauelemente bei ihrer Weiterverarbeitung der weitere Nachteil, dass infolge von äusseren Einflüssen, z.B. Luftfeuchtigkeit, Temperaturbelastungen und ähnlichem, ein wechselndes Dehnverhalten der Bandträger eintritt, so dass das Zusammenwirken von Perforationslöchern und den in sie bei Bearbeitungsprozessen eingreifenden Mitnehmern, z.B. Stiften oder Zähnen, nicht mehr passgenau erfolgt und die Bandträger deshalb in den entsprechenden obengenannten Bearbeitungsvorrichtungen nicht mehr weitertransportiert werden können.

Der Erfindung liegt die Aufgabe zugrunde, eine Vorrichtung anzugeben, mit der diese genannten Fehlerquellen beim Transport von gegurteten Bauelementen ausgeschaltet werden und bei welcher es auch nicht erforderlich ist, den Bandträger mit Perforationslöchern zu versehen.

Diese Aufgabe wird erfindungsgemäss gelöst durch ein in der Be- oder Verarbeitungsvorrichtung umlaufendes endloses Transportband, auf dem Spitzen angeordnet sind, die in das Material des vor dem Transportband an dieses andrückbar geführten Bandträgers eindringen.

Nach einer weiteren vorteilhaften Ausbildung der Erfindung sind die Spitzen in einem regelmässigen Abstand von maximal 35 cm auf dem Transportband angeordnete Nadeln eines maximalen Durchmessers von 1 mm.

Die Nadeln können in das Material des Bandträgers eindringen, worunter auch ein Hindurchdringen zu verstehen ist.

Nach einer weiteren vorteilhaften Weiterbildung der Erfindung ist der Bandträger mittels einer gefederten Andruckvorrichtung gegen das Transportband drückbar.

Die mit der Erfindung erzielten Vorteile bestehen insbesondere darin, dass unter allen Umständen ein einwandfreier Sitz und Transport von Bandträgern in einer beliebigen Be- oder Verarbeitungsvorrichtung gewährleistet ist. Ein weiterer Vorteil ist, dass Bandträger unterschiedlichster Abmessungen mit ein und demselben Transportband in einer Be- oder Verarbeitungsvorrichtung transportiert und positioniert werden können und dass es ausserdem nicht erforderlich ist, die Be- oder Verarbeitungsvorrichtung umzurüsten, wenn Bandträger unterschiedlicher Schritt- oder Rastermasse (Abstand der Bauelemente) be- oder verarbeitet werden sollen.

Die Spitzen auf dem Transportband gemäss der Erfindung können an beliebigen Stellen in einen Bandträger eindringen und ihn für den weiteren Transport massgenau positionieren und halten; selbst wenn eine auf dem Transportband angebrachte Spitze den Bandträger an einer Stelle treffen sollte, auf der sich an der dem Transportband abgekehrten Seite ein elektrisches Bauelement mit einem seiner Anschlussdrähte befindet, kann die Spitze bei den üblicherweise angewendeten runden Anschlussdrähten trotzdem den Bandträger durchdringen, weil sie sich auf Grund ihrer Geometrie und auf Grund der Geometrie des Anschlussdrahtes an diesem vorbeischiebt. Ein weiterer wichtiger Vorteil ist, dass in Bandträgern überhaupt keine Perforationslöcher mehr angebracht werden brauchen, womit die vorne genannten Schwierigkeiten bei der Herstellung der Perforationslöcher ausgeschaltet sind.

Anhand der Zeichnung wird ein Ausführungsbeispiel der Erfindung beschrieben und ihre Wirkungsweise erläutert. Es zeigen:

Fig. 2 eine Draufsicht auf ein Transportband gemäss der Erfindung mit angedrücktem Bandträger, und

Fig. 3 eine Seitenansicht einer Andruckvorrichtung mit Transportband und Bandträger gemäss der Erfindung zum Teil im Schnitt.

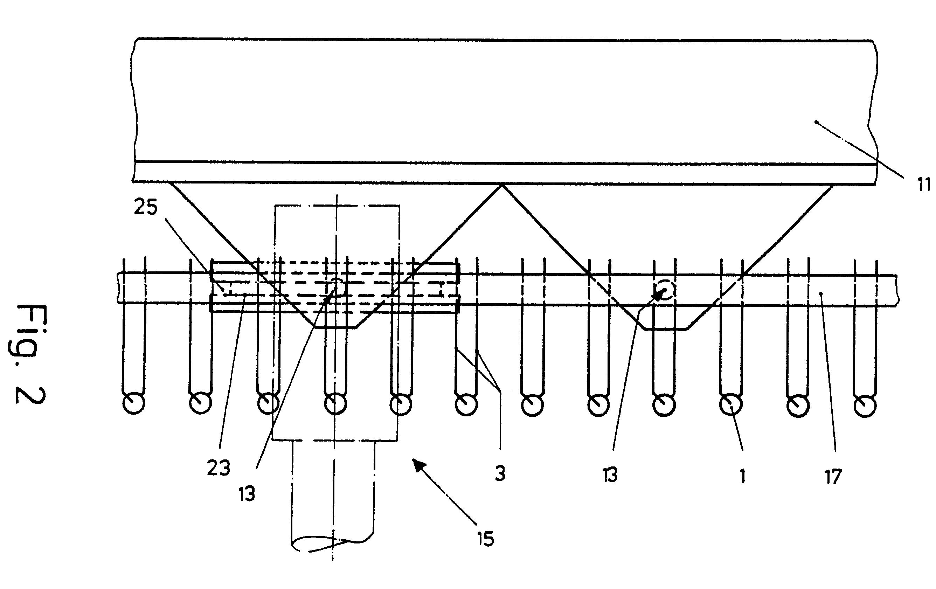

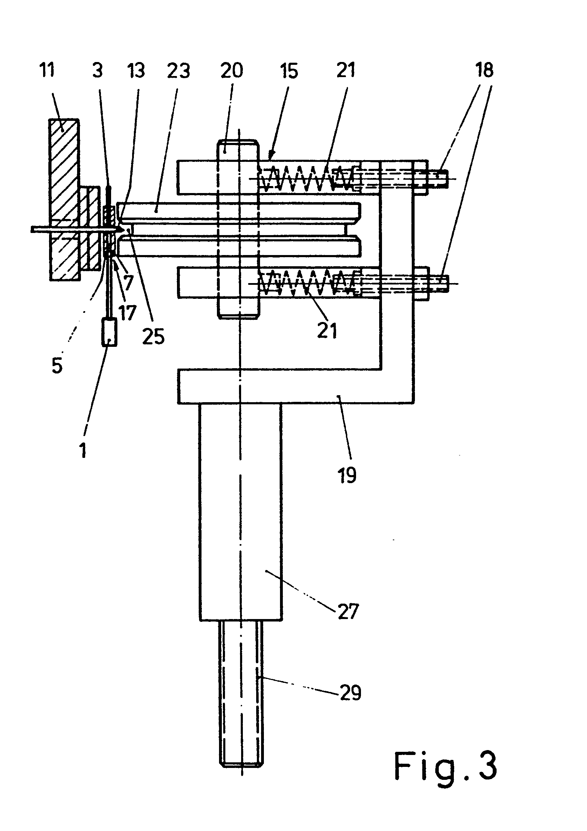

In Fig. 2 ist ein endloses Transportband 11, z.B. in Form einer Kette gemäss der Erfindung mit Spitzen 13 dargestellt. Die Spitzen 13 sind als Nadeln ausgebildet. Gegen die Spitzen 13 auf dem Transportband 11 ist ein vor dem Transportband 11 geführter Bandträger 17 mittels einer gefederten Andruckvorrichtung 15 gedrückt, wobei die Spitzen 13 in den Bandträger 17 eindringen oder ihn durchdringen. Auf dem Bandträger 17, der z.B. aus einem Tragband und einem Klebeband bestehen kann, sind elektrische Bauelemente 1 mit ihren Anschlussdrähten 3 befestigt. In der Zeichnung sind die Spitzen 13 auf dem Transportband 11 so dargestellt, dass sie den Bandträger 17 gerade zwischen jeweils den beiden Anschlussdrähten 3 eines elektrischen Bauelementes 1, z.B. eines Scheibenkondensators, durchdringen; dies muss nicht zwingend der Fall sein. Da die Spitzen 13 sehr fein sind — sie sind bei dem Ausführungsbeispiel aus 0,7 mm dickem Draht, z.B. aus Stahl, gefertigt, der an seiner, dem Transportband abgekehrten Seite angespitzt wurde, um das Eindringen in das Material des Bandträgers zu erleichtern —, können sie den Bandträger praktisch an jeder beliebigen Stelle, wo sie gerade auf ihn treffen, durchdringen. Auch die Stellen des Bandträgers 17, auf denen zufällig Anschlussdrähte 3 der elektrischen Bauelemente 1 liegen, stellen kein Hindernis für die Spitzen 13 dar, denn durch eine gewisse Elastizität des Materials des Bandträgers bzw. des in Fig. 2 nicht dargestellten, im allgemeinen hinter dem Klebeband 7 liegenden Tragbandes 5 (vgl. Fig. 3) drückt sich die feine Spitze 13 an den Anschlussdrähten 3 vorbei in das Material des Bandträgers z.B. aus Tragband und Klebeband.

In Fig. 3 ist die Andruckvorrichtung 15 dargestellt, die das Transportband 11 mit den Spitzen 13 an das Material des Bandträgers aus Tragband 5 und Klebeband 7 mit zwischen beiden mit ihren Anschlussdrähten 3 befestigten elektrischen Bauelementen 1 andrückt, wobei die Spitzen 13 in das Tragband 5 und das Klebeband 7 eindringen, bzw. die beiden Bänder durchdringen, wodurch der Bandträger sicher gehalten, positioniert und weitertransportiert werden kann, ohne dass die Gefahr besteht, dass der Bandträger von den Spitzen 13 im Verlaufe eines Fertigungsschrittes abrutscht und der laufende Prozess deswegen unterbrochen werden muss.

Ein Andruckrad 23 ist mittels einer Schraube 20 in einem Halterahmen 19 befestigt, der über einen Zapfen 27 mit einem Gewinde 29, auf das z.B. eine Mutter oder Flügelschraube aufschraubbar ist, in einer mit der Andruckvorrichtung 15 zu bestückenden Maschine befestigt werden kann. Die Andruckkraft des Andruckrades 23 ist über Federn 21 regulierbar mittels Stellschrauben 18.

Eine Nut 25 bildet einen Freiraum zur Aufnahme jeweils der über den Bandträger 17 hinausragenden Spitze 13.

Das Transportband 11, z.B. in Form einer endlosen Kette, mit den Spitzen 13, die in einen zu transportierenden Bandträger eindringen können, kann unter Einbeziehung der Andruckvorrichtung 15 gemäss Fig. 3 mit Vorteil in allen Vorrichtungen eingesetzt werden, in denen gegurtete Bauelemente kontinuierlich oder auch schrittweise Be- oder Verarbeitungsprozessen unterzogen werden sollen.

## Patentansprüche

1. Vorrichtung zum Transportieren von auf einem Bandträger mit ihren Anschlussdrähten angeordneten elektrischen Bauelementen in einer Be- oder Verarbeitungsvorrichtung, gekennzeichnet durch ein in der Be- oder Verarbeitungsvorrichtung umlaufendes endloses Transportband (11), auf dem Spitzen (13) angeordnet sind, die in das Material des vor dem Transportband an dieses andrückbar geführten Bandträgers (17; 5, 7) eindringen.

2. Vorrichtung nach Anspruch 1, dadurch gekennzeichnet, dass die Spitzen (13) in einem regelmässigen Abstand von maximal 35 cm auf dem Transportband (11) angeordnete Nadeln eines maximalen Durchmessers von 1 mm sind.

3. Vorrichtung nach Anspruch 1, dadurch gekennzeichnet, dass der Bandträger (17; 5, 7) mittels einer gefederten Andruckvorrichtung (15) gegen das Transportband (11) drückbar ist.

## Claims

1. A device for the transport of electrical components mounted with their connection wires on a carrier tape in a machining or processing equipment, characterized by an endless conveyor belt (11) which passes through the machining or processing equipment and on which are arranged pointed elements (13) which penetrate into the material of the carrier tape (17; 5, 7) which is guided so as to be urged against the conveyor belt.

2. A device as claimed in claim 1, characterized in that the pointed elements (13) are needles arranged at regular intervals of at most 35 cm on the conveyor belt (11) and having a maximum diameter of 1 mm.

3. A device as claimed in claim 1, characterized in that the carrier tape (17; 5, 7) can be urged against the conveyor belt (11) by means of a spring-loaded pressure device (15).

## Revendications

1. Dispositif servant à transporter des composants électriques placés sur un ruban de support par leurs fils de connexion dans un dispositif d'usinage ou de traitement, caractérisé par une bande transporteuse (11) sans fin qui est animée d'un mouvement de translation dans le dispositif d'usinage ou de traitement et sur laquelle sont disposées des pointes (13) pénétrant dans le matériau du ruban de support (17; 5, 7) avancé devant la bande transporteuse et pouvant être appuyé contre celle-ci.

2. Dispositif selon la revendication 1, caractérisé en ce que les pointes (13) sont des aiguilles d'un diamètre maximal de 1 mm disposées sur la bande transporteuse (11) à des écarts réguliers de 35 cm au maximum.

3. Dispositif selon la revendication 1, caractérisé en ce que le ruban de support (17; 5, 7) peut être appuyé contre la bande transporteuse (11) au moyen d'un dispositif de pression (15) muni de ressorts.

Fig. 1

Fig. 2

Fig.3